# EUROPEAN PATENT SPECIFICATION

(11) **EP 1 899 496 B1**
(45) Date of publication and mention of the grant of the patent: **12.06.2013**
(21) Application number: 06749298.3
(22) Date of filing: 04.04.2006
(51) Int. Cl.: C23C 14/06, C23C 14/58, C23C 16/26, C23C 16/56

(54) **HYDROPHILIC DLC ON SUBSTRATE WITH BARRIER DISCHARGE PYROLYSIS TREATMENT**
HYDROPHILER DLC AUF SUBSTRAT MIT BARRIEREENTLADUNGSPYROLYSEBEHANDLUNG
DLC HYDROPHILE POSITIONNE SUR UN SUBSTRAT ET SOUMIS A UN TRAITEMENT PYROLYTIQUE DE DECHARGE ISOLANT

(30) Priority: 29.04.2005 US 117724
(43) Date of publication of application: 19.03.2008
(73) Proprietor: GUARDIAN INDUSTRIES CORP., Auburn Hills, Michigan 48326-1714 (US)
(72) Inventor: BIENKIEWICZ, Joseph, M., Ann Arbor, Michigan 48108 (US); WEIDL, Roland, 07646 Bollberg (DE); GITTER, Uwe, 07629 Hermsdorf (DE); GRUENLER, Bernd, E., 07537 Zeulenroda (DE)
(74) Representative: Hess, Peter K. G.
(86) International application number: PCT/US2006/012590
(87) International publication number: WO 2006/118735

(56) References cited:
- EP-A- 0 785 475
- US-A- 5 073 785
- US-A- 5 965 629
- US-A1- 2002 127 404
- US-A1- 2003 099 835
- US-A1- 2003 148 401
- US-A1- 2004 020 761
- US-A1- 2004 067 363
- US-A1- 2004 067 368
- US-B2- 6 793 979
- TAMAHASHI K. ET AL: "Investigation of passivation films for a-Si:H photoreceptors (III). Properties of a-C films." DENSHI SHASHIN GAKKAISHI /19000101, vol. 27, no. 1, 27 January 1988 (1988-01-27), pages 24-30, XP008095074
- BUGAEV ET AL: "a-C:H films deposited in the plasma of barrier and surface discharges at atmospheric pressure" SURFACE AND COATINGS TECHNOLOGY, ELSEVIER, AMSTERDAM, NL, vol. 96, no. 1, 3 November 1997 (1997-11-03), pages 123-128, XP005494646 ISSN: 0257-8972

## Description

Certain example embodiments of this invention relate to a hydrophilic coating including diamond-like carbon (DLC) provided on (directly or indirectly) a substrate of glass, plastic, or the like, and a method of making the same. More particularly, this invention relates to a DLC inclusive coating that is treated using barrier discharge in order to cause the DLC inclusive coating to become hydrophilic and/or to reduce its contact angle θ.

### BACKGROUND OF THE INVENTION

It is often desirable to provide a hydrophilic coating (e.g., anti-fog coating) on a substrate such as an automotive windshield, automotive window, automotive mirror, architectural mirror, bathroom mirror, architectural window, or the like. Such coatings may reduce the likelihood of water drops deposited on the substrate taking globular shape(s), thereby permitting visibility to be improved. In other words, hydrophilic coatings function to reduce bead-like condensation on substrate surfaces (e.g., on the interior surface of an automotive windshield or window, IG window unit, or the like). In essence, a hydrophilic coating can reduce the formation of many tiny droplets of liquid which can scatter light on a surface (i.e., make condensation on a surface film-wise as opposed to droplet-wise).

Unfortunately, certain hydrophilic coatings are not as durable and/or hard as would otherwise be desired and thus are not efficient from a practical point of view for applications such as automotive windshields and/or other types of windows or mirrors.

U.S. Patent No. 6,713,179, hereby incorporated herein by reference, discloses a layer comprising diamond-like carbon (DLC) that is treated with ultraviolet (UV) radiation in order to cause it to become hydrophilic (i.e., the UV exposure causes the contact angle θ of the layer to decrease). While this process of making a hydrophilic DLC inclusive layer works well, it takes much time. The example in U.S. Patent No. 6,713,179 states that the DLC was treated with QUV for 86 hours in order to cause the contact angle θ of the DLC to drop from 73.47 degrees to 19.12 degrees (i.e., this contact angle reduction of 74% took 86 hours). It would be desirable if a DLC inclusive layer could be made to be hydrophilic via a less time-consuming process.

U.S. Patent Document 2004/0067363 discloses treating DLC with an ion beam and hot water in order to cause contact angle θ to be reduced. In such systems, the ion beam treatment is often performed as the last vacuum step in a coater or the like, and subsequent exposure to hot water can be performed in an exit bath. However, since vacuum space is valuable and capital intensive, and it would be desirable if a system for causing contact angle θ of DLC to be reduced could be developed which could optionally be performed in an ambient atmosphere where no vacuum is required.

The scientific article *"*Investigation of passivation films for a-Si:H photoreceptors. Properties of a - C films" by Tamahashi et al. discloses to subject hydrogenated amorphous carbon coatings to a corona discharge to increase the hydrophilic properties of the layers. However, the corona discharge time necessary to achieve substantial degrees in contact angle is in the range of several hours, which makes this procedure difficult to implement in practice.

Prior art documents EP 0 785 475 A2 and US 5,965,629 disclose the use of an ion-beam treatment to alter the surface properties of certain substrates.

In view of the above, it is apparent that there exists a need in the art for one or more of (i) a coated article (e.g. coated glass or plastic substrate) having hydrophilic properties, and/or a method of making the same, (ii) a protective hydrophilic coating for window and/or minor substrates that is somewhat resistant to scratching, damage, (iii) a technique for causing contact angle θ of DLC to be reduced which may be performed in an ambient atmosphere where no vacuum is required, and/or (iv) a process for reducing a contact angle of DLC in a less time-consuming manner.

It is a purpose of different embodiments of this invention to fulfill any or all of the above described needs in the art, and/or other needs which will become apparent to the skilled artisan once given the following disclosure.

### SUMMARY OF EXAMPLE EMBODIMENTS OF THE INVENTION

In certain example embodiments of this invention, there is provided a durable coated article that is less likely to attract or be affected by bead-like liquid condensation. Exemplary applications to which such hydrophilic coating(s) may be applied include, for example without limitation, automotive windshields, automotive backlites (i.e., rear vehicle windows), automotive side windows, architectural windows, mirrors, coated glass used for table furniture, etc.

According to the invention a layer comprising diamond-like carbon (DLC) is subjected to at least a barrier discharge treatment. Surprisingly, it has been found that the barrier discharge treatment causes the contact angle θ of the DLC inclusive layer to drop/decrease in a relatively short period of time. In certain example embodiments, the layer comprising DLC may additionally be treated with an ion beam(s) including oxygen, and/or a hot liquid and/or vapor such as hot water in order to cause the contact angle of the layer comprising DLC to also decrease in a relatively short period of time.

In certain example embodiments, it has been found that the barrier discharge treatment of a DLC inclusive layer oxidizes the surface of the DLC inclusive layer thereby causing its contact angle θ to quickly drop in a short period of time. In certain example embodiments, the barrier discharge causes an atmospheric plasma to be struck, and the glow discharge of the plasma produces oxygen radicals that end up moving toward and contacting the DLC inclusive layer. These oxygen radicals from the plasma cause at least the surface of the DLC inclusive layer to oxidize which in turn causes its contact angle θ to quickly drop in a short period of time.

Due to the provision of the DLC in certain example instances, a scratch resistant hydrophilic coating may be provided.

In certain example embodiments of this invention, there is provided a coated article, wherein a layer of the coating includes both sp² and sp³ carbon-carbon bonds and has a surface energy Υ_{c} of at least about 20 mN/m, more preferably at least about 24 mN/m, and most preferably at least about 26 mN/m.

Certain example embodiments of the instant invention provide a method of making a coated article, the method comprising: depositing a layer comprising diamond-like carbon (DLC) on a substrate; after said depositing, subjecting the layer comprising DLC to a barrier discharge treatment in order to reduce a contact angle θ of the layer comprising DLC.

This invention will now be described with respect to certain embodiments thereof, along with reference to the accompanying illustrations.

### IN THE DRAWINGS

Figure 1 is a side cross sectional view of a coated article according to an example embodiment of this invention, wherein a substrate is provided with at least a layer of or including DLC thereon and is subjected to at least a barrier discharge treatment in order to cause the layer's contact angle θ to decrease.

Figure 2 is a side cross sectional view of a coated article according to another example embodiment of this invention, wherein a substrate is provided with at least a layer of or including DLC thereon and is subjected to a barrier discharge treatment and optional hot water (in liquid and/or vapor form) treatment in order to cause the layer's contact angle θ to decrease.

Figure 3(a) is a flowchart according to an example embodiment of this invention, illustrating that at least barrier discharge treatment may be used for causing the contact angle θ of a DLC inclusive layer to decrease.

Figure 3(b) is a flowchart according to another example embodiment of this invention, illustrating that ion beam treatment, barrier discharge treatment, and hot water treatment may be used for causing the contact angle θ of a DLC inclusive layer to decrease.

Figure 4 is a side cross sectional partially schematic view illustrating a contact angle θ of a drop (e.g., sessile drop of water) on an uncoated glass substrate.

Figure 5 is a side cross sectional partially schematic view illustrating a high contact angle θ of a drop on a coated article including a hydrophobic coating of, for example, an article disclosed in U.S. patent application 09/442,805.

Figure 6 is a side cross sectional partially schematic view illustrating a low contact angle θ of a drop (e.g., sessile drop of water) on a coated article according to an example embodiment of this invention (following one or more of barrier discharge treatment, ion beam treatment and/or hot liquid treatment).

Figure 7 is a side cross sectional view of an example ion beam source which may be used in any embodiment of this invention for depositing a DLC inclusive layer(s) and/or for ion beam treating a layer of or including DLC in order to cause its contact angle θ to decrease.

Figure 8 is a perspective view of the linear ion beam source of Figure 7.

Figure 9 is an example barrier discharge treatment according to an example non-limiting embodiment of this invention.

### DETAILED DESCRIPTION OF

### CERTAIN EXAMPLE EMBODIMENTS OF THIS INVENTION

Referring now more particularly to the accompanying drawings in which like reference numerals indicate like elements/steps throughout the accompanying views.

Certain example embodiments of this invention relate to improving hydrophilic qualities of a coated article (e.g., automotive windshield, automotive backlite, automotive side window, snow-mobile windshield, architectural window, mirror, coated glass for use in furniture, etc.) by providing a diamond-like carbon (DLC) inclusive layer or coating on a substrate in a manner such that the resulting article and/or layer has hydrophilic qualities or characteristics. Certain other embodiments of this invention relate to lowering the contact angle θ of a layer comprising DLC, regardless of whether or not the final contact angle ends up rendering the coated article hydrophilic.

Surprisingly, it has been found that the contact angle θ of a layer of or including DLC can be decreased by subjecting the DLC inclusive layer to barrier discharge treatment after it has been deposited by ion beam deposition or the like.

In the barrier discharge treatment, an atmospheric plasma may be struck over the DLC, and the glow discharge thereof produces oxygen radicals that impinge upon the DLC inclusive layer in order to oxidize or further oxidize at least a surface of the DLC inclusive layer. It has been found that the barrier discharge treatment increases the polar component of the DLC inclusive layer's surface energy, which in turn increases the layer's total surface energy. The higher the surface energy, the more hydrophilic the layer and the lower the contact angle θ. Thus, by increasing the surface energy via the barrier discharge treatment, the hydrophilicity of DLC can be improved and thus the contact angle θ lowered. In certain example embodiments, it has been found that subjecting the DLC inclusive layer to barrier discharge treatment a DLC inclusive layer causes the surface of the DLC inclusive layer to at least partially oxidize thereby causing its contact angle θ to quickly drop in a short period of time (e.g., in seconds or minutes, as opposed to the tens of hours).

In certain example embodiments, the barrier discharge treatment of the DLC inclusive layer causes the contact angle θ of the DLC inclusive layer to drop (decrease) at least about 5%, more preferably at least about 10%, still more preferably at least about 20%, even more preferably at least about 40%, still more preferably at least about 50%, and sometimes even at least about 60%. The contact angle θ of the DLC inclusive layer before barrier discharge treatment may or may not be hydrophilic, but after said barrier discharge treatment, ion beam treatment and/or hot liquid/vapor treatment the contact angle θ may less than about 65 degrees, sometimes less than about 50 degrees, sometimes less than about 40 degrees, more preferably less than about 30 degrees, more preferably less than about 25 degrees. When the ion beam treatment of the DLC and the barrier discharge treatment of the DLC are both performed, and the ion beam treatment is performed prior to the barrier discharge treatment, the bulk of the reduction in contact angle may occur due to the ion beam treatment and the reduction in contact angle due to the barrier discharge treatment may be to a lesser extent than that discussed above.

Barrier discharge is typically known as a process in which a plasma is struck in any suitable manner (e.g., via electrodes). As explained herein, the glow discharge thereof produces oxygen radicals which end up impinging upon the DLC inclusive layer and caused at least a surface of the DLC inclusive layer to oxidize or further oxidize. Examples of barrier discharge are disclosed in, for example and without limitation, U.S. Patents Nos. 6,831,421, 6,821,906, 6,631,726, 6,664,737 and 6,818,102. Any of these barrier discharge techniques, or any other suitable barrier discharge technique, may be used to treat the DLC in different embodiments of this invention. In certain example barrier discharge treatment systems, an alternating voltage may be applied to first and second electrodes which are covered by dielectric barriers. A voltage may induce between the dielectrics and after it reaches the breakdown voltage, a discharge occurs. Homogeneous barrier discharge (Townsend or glow type) may be used in certain example embodiments of this invention.

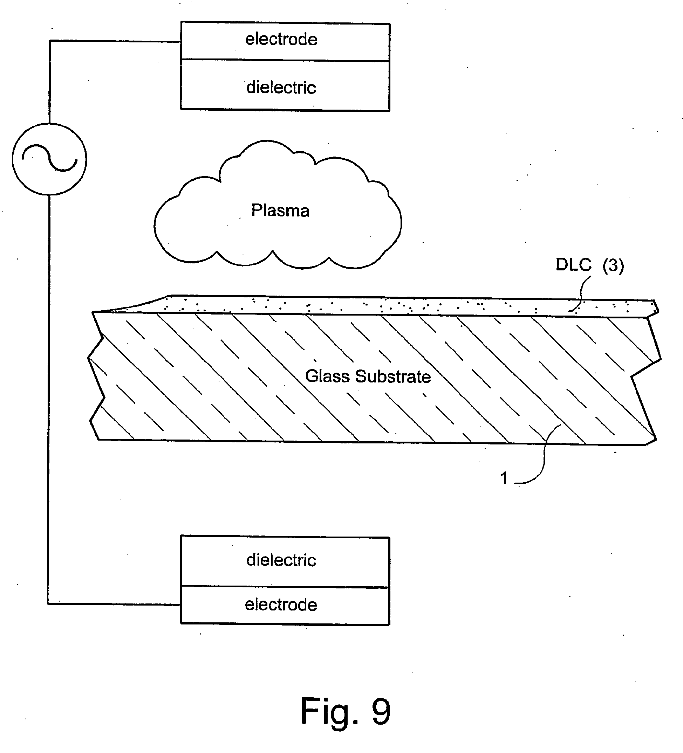

Referring to Fig. 9, an example type of barrier discharge treatment that may be used in certain example embodiments of this invention is a substantially parallel-plate type of barrier discharge treatment. In this type of barrier discharge treatment, first and second electrodes are placed on opposite sides of the coated article (e.g., the first electrode above the substrate and the second electrode below the substrate). The sides of the electrodes facing the substrate may be coated with a dielectric in certain example embodiments. An alternating voltage is applied to the electrodes covered by the dielectric barriers, and a voltage induces between the dielectrics and after it reaches the breakdown voltage a discharge occurs. The plasma is typically located at a position over the layer comprising DLC. The discharge current may in certain example instances be limited due to the presence of the dielectric barriers. Example speeds that the substrate can be moved at are from 5 to 500 meters/minute, and sometimes from 5-30 meters/minute in certain example embodiments of this invention. However, in other example embodiments of this invention, the glass substrate 1 may act as the dielectric for the lower electrode so that the dielectric coating shown in Fig. 9 on the lower electrode is optional. The plasma may or may not contact the DLC 3 and/or substrate 1 in different embodiments of this invention.

The activation of the DLC surface (i.e., to reduce the contact angle of the DLC inclusive layer) when using barrier discharge may be achieved due to the action of the oxygen radicals at or proximate the DLC surface, by (a) surface modification of the DLC inclusive layer such as at least partially oxidizing the DLC inclusive layer's surface.

Significant example advantages associated with the use of barrier discharge to reduce DLC contact angle θ are (i) the barrier discharge may be used in an ambient atmosphere (i.e., atmospheric pressure) and thus need not occupy valuable and limited vacuum space, and (ii) the barrier discharge may be a dry process with less adverse impact on second surface products which are sensitive to water contact such as when a low-E coating is provided on the other or same side of the glass substrate.

Combining the hydrophilicity with the use of an amorphous diamond-like carbon (DLC) layer/coating provided on the base substrate (e.g., glass substrate) permits the resulting coated article to have a low contact angle θ as well as surface hardness and scratch resistant characteristics sufficient such that the article may be used in automotive, window, and/or other high exposure environments where durability is desired. Optionally, polar inducing dopant(s) (e.g., B, N, P, As, S, Sb, Ga, In, and/or any other polar inducing dopant) may be provided in the DLC (in addition to the ion beam treatment) so as to help the DLC become more polar, which in turn increases surface energy and thus provides for a more hydrophilic coating. In certain optional embodiments, UV treatment may also be used to cause the contact angle θ of the DLC inclusive layer to decrease and/or stay low.

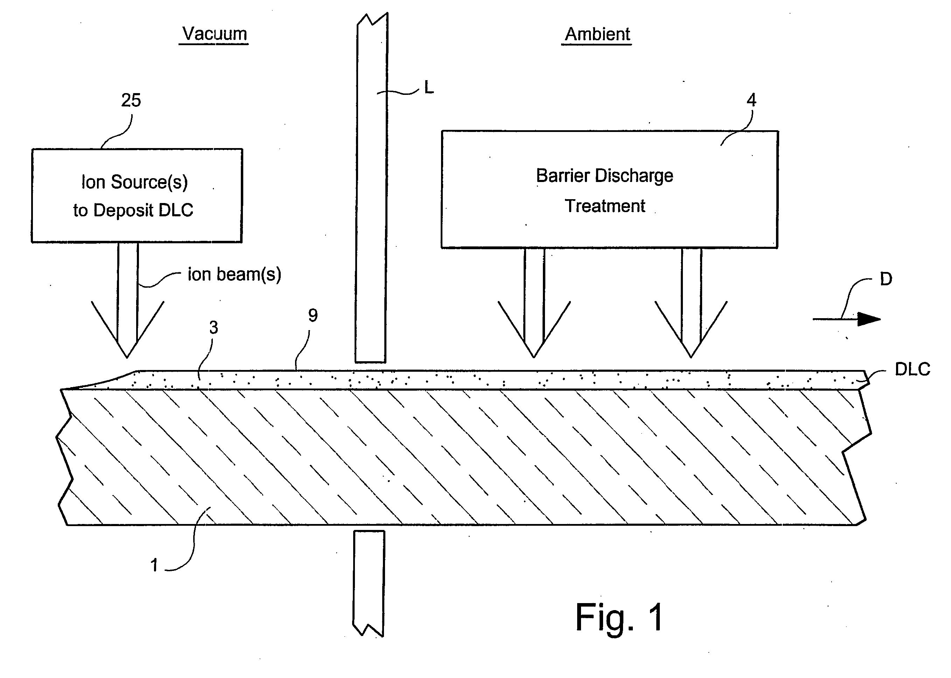

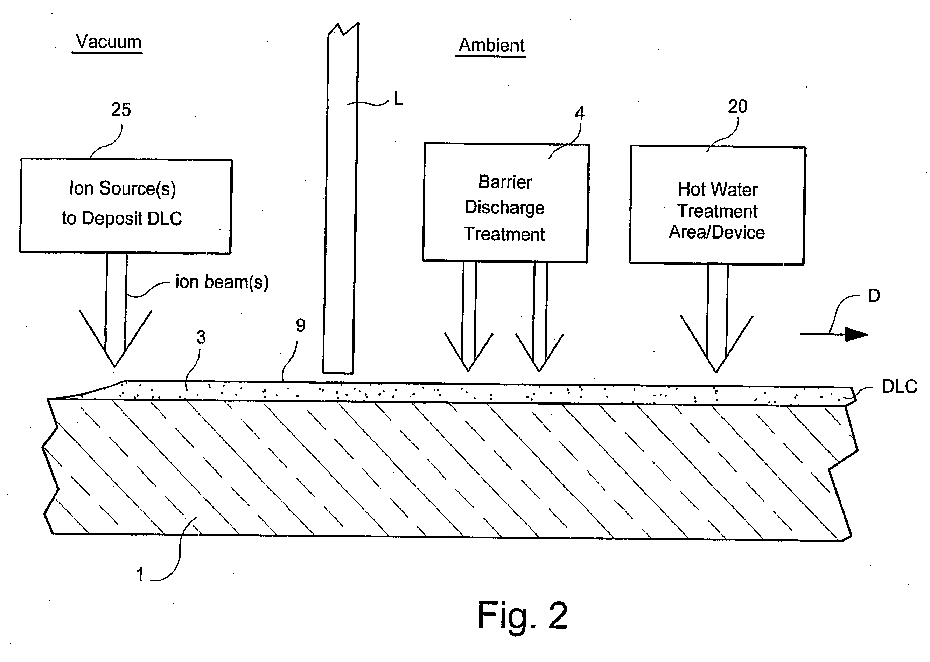

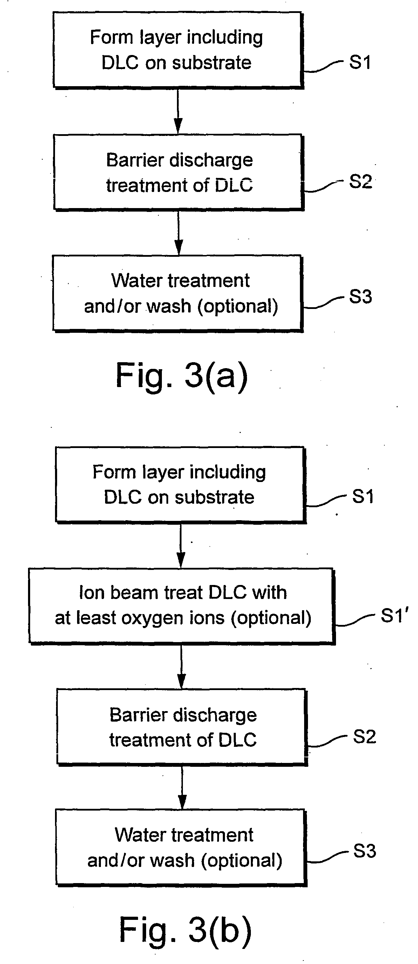

Figure 1 is a side cross-sectional view of a coated article according to an example embodiment of this invention, wherein at least one diamond-like carbon (DLC) inclusive protective coating(s) or layer 3 is provided on substrate 1. The coated article has an exterior or outer surface 9. Substrate 1 may be of glass, plastic, ceramic, or the like. Optionally, other layer(s) (e.g., a dielectric layer(s) and/or a multi-layered low-E coating - not shown) may be provided between the DLC inclusive layer 3 and the substrate 1 in certain embodiments of this invention. Fig. 1 illustrates that as the coated substrate moves in direction D, the DLC layer 3 is subjected to barrier discharge by a barrier discharge treatment system 4. Fig. 2 is similar to Fig. 1, except that in the Fig. 2 embodiment a hot water treatment may be performed on the DLC inclusive layer 3 in addition to the barrier discharge treatment. While Figs. 1-2 illustrates the ion source 25 for depositing the DLC layer 3, the DLC layer 3 itself, and the barrier discharge system 4 on the top side of the substrate 1, these components and layer may instead be on the bottom side of the substrate in certain example embodiments of this invention. Fig. 3(a) is a flowchart illustrating steps taken in order to reduce the contact angle θ of the DLC layer 3 in certain embodiments of this invention.

Referring to Figs. 1, 2 and 3(a), layer 3 comprising DLC may be ion beam deposited on substrate 1 using an ion beam(s) from ion source(s) 25 in a vacuum environment having a pressure less than atmospheric (see S1 in Fig. 3(a)). Optionally, other layer(s) may be on the substrate under the DLC layer 3. The term "on" (with regard to a layer being "on" a substrate or other layer) herein means supported by, regardless of whether or not other layer(s) are provided therebetween, and regardless of which side of the substrate the layer is located. Thus, for example, DLC inclusive layer 3 may be provided directly on substrate 1 as shown in Fig. 1, or may be provided on substrate 1 with a low-E coating or other layer(s) therebetween. Example layer systems (in full or any portion of these coatings) that may be used as low-E or other coating(s) on substrate 1 between DLC layer 3 and the substrate are shown and/or described in any of U.S. Patent Nos. 5,837, 108, 5,800,933, 5,770,321, 5,557,462, 5,514,476, 5,425,861, 5,344,718, 5,376,455, 5,298,048, 5,242,560, 5,229,194, 5,188,887, 3,682,528, 5,011,745, WO 02/04375 (U.S. Serial No. 09/794,224) and 4,960,645. These optional coatings are provided for purposes of example and are not intended to be limiting.

As deposited, the layer 3 comprising DLC may be deposited as any of the DLC inclusive layer(s) in any of U.S. Patent Nos.6,303,226 and/or 6,303,225, or in any other suitable manner/form. Thus, the layer 3 comprising DLC may have more sp³ carbon-carbon bonds than sp² carbon-carbon bonds either throughout the entire layer and/or in at least one 10 angstrom (Å) thick portion thereof. Moreover, the DLC layer 3 is preferably entirely or at least partially amorphous and may or may not be hydrogenated in certain embodiments. For example, the DLC layer 3 may include from about 1-25% H in certain embodiments, more preferably from about 5-20% H, and most preferably from about 7-18% H in certain embodiments of this invention. In certain embodiments, DLC layer 3 may be from about 10 to 1,000 Angstroms thick, more preferably from about 50 to 250 Angstroms thick. Moreover, in certain exemplary embodiments of this invention, layer 3 has an average hardness of at least about 10 GPa, more preferably of at least about 20 GPa, and even more preferably of at least about 50 GPa. Also, the DLC layer 3 may have an average density of at least about 2.4 grams/cm² (more preferably from about 2.5 to 3.0 grams/cm²) in certain example embodiments of this invention.

After the DLC inclusive layer 3 is deposited on the substrate 1 using ion source(s) 25 in a vacuum atmosphere (i.e., at a pressure less than atmospheric pressure) in S1, the coated substrate moving in direction D exits the in-line coater via load lock L, and travels past the barrier discharge treatment system 4 for barrier discharge treatment (see S2 in Fig. 3(a)). The barrier discharge treatment is performed on the DLC inclusive layer 3, thereby causing its contact angle to be decreased as explained herein.

Optionally, as shown in Fig. 2, in addition and subsequent to the barrier discharge treatment, the surface 9 of the DLC inclusive layer 3 may be treated with a hot liquid and/or vapor at area 20 in order to cause its contact angle θ to further decrease (see S3 in Fig. 3(a)). In an example embodiment of this invention, the surface 9 of the DLC layer 3 is exposed to hot water (in liquid and/or vapor form). In certain example embodiments, the hot water may be at a temperature of from 50 to 200 degrees C, more preferably from about 70 to 200 degrees C, even more preferably from about 80 to 150 degrees C. It has been found that temperatures lower than this do not result in the desired contact angle reduction of surface 9 of DLC layer 3. This hot water treatment may be combined with a washing step in certain example embodiments of this invention.

After being treated with barrier discharge in order to reduce contact angle, the coated article is packaged and processed as is regular glass in certain example embodiments of this invention.

The flowchart of Fig. 3(b) illustrates another example embodiment of this invention. In particular, referring to Figs. 1-2 and 3(b), prior to subjecting the DLC layer 3 to barrier discharge treatment, the outer surface 9 of the DLC inclusive layer 3 (i.e., the surface farthest from the substrate 1) may first be ion beam treated using at least one ion source (and thus at least one ion beam) in order to cause the contact angle θ of the layer 3 to decrease (see step S1' in Fig. 3(b)). This ion treatment may take place as the coated substrates moves in direction D under one or more ion source(s), or alternatively while the substrate remains still and the ion source(s) move with respect thereto. When oxygen and/or nitrogen gas are used in the ion beam source(s) for example, the ion beam treatment of the surface 9 of the coated article causes the outer surface of the layer 3 to at least partially oxidize thereby causing the contact angle to quickly drop (optionally, oxygen with no nitrogen may instead be used as a gas in the ion source which generates the ion beam). This ion beam treatment may be performed in the vacuum area of the coating apparatus, which is at a pressure less than atmospheric (i.e., before the coated article exits via the load lock). The use of oxygen gas (optionally with N, H, and/or other gas) causes the resulting ion beam(s) that is directed toward surface 9 to include O₂⁻, O⁻ and/or OH- ions (ions including at least oxygen ions). One or more of these ions hit the surface 9 of the DLC inclusive layer 3 and cause its contact angle θ to drop. Presumably, the contact angle drops because C=O-H, C=O, and/or C-O bonds (i.e., oxygen-carbon bonds and/or oxygen-hydrogen-carbon bonds) form at the surface 9 of the DLC inclusive layer 3 thereby causing its surface energy to rise. In other words, the ion beam treatment introduces oxygen to the surface 9 of the DLC inclusive layer 3, which is believed to be a primary reason why the contact angle is caused to quickly drop. By tuning the gas composition, ion energy, and throw distance in the beam(s), one may be able to run such a treating process at speeds of 100 in./minute or more, and still achieve hydrophilic surface(s). Oxygen is a preferred example gas to be used in a treating ion beam source(s), although other gases may be used instead of or in addition to oxygen in different embodiments of this invention so long as they cause the contact angle to decrease. When N is used in a gas in one or more of the ion beam source(s) for the ion beam treatment (e.g., in combination with oxygen and/or hydrogen gas), the resulting N ions tend to make the surface of DLC layer 3 more electrically conductive than the glass which may be desirable in some instances. In other embodiments, water vapor may be used as a feed gas in at least one of the ion beam treating source(s). Resulting ions can end up being subimplanted in the surface of layer 3, and the polar nature of these ions/molecules when water vapor gas is used can significantly reduce the static potential which can attract dust particles thereby enabling the coating to be more resistant to dust accumulation. In still other embodiments, the ion treatment may use H₂O₂ gas in at least one of the ion beam sources used for the treating. Again, the O₂⁻, O⁻ and/or OH⁻ ions hit the surface 9 of the DLC inclusive layer 3 and cause contact angle θ to drop as discussed above. Other gases may also be used in other embodiments of this invention. It is noted that the ion beam treatment, while causing the contact angle of layer 3 to decrease, may cause some portion (e.g., 0-20 angstroms) of the layer 3 to be removed during the ion beam treatment process. Thus, it will be appreciated that various gas(es) may be used in an ion source(s) for generating an ion beam(s) including oxygen for treating the surface of the DLC inclusive layer, with example gases including, but not limited to, O₂, H₂O, H₂O₂, N₂O, CO₂, and/or the like. The angle α at which the ion beam(s) hits the surface 9 of DLC inclusive layer 3 during the ion beam treatment may be from about 1-90 degrees in different embodiments of this invention. However, in certain embodiments, the angle α that the beam(s) makes with the surface 9 of the coated article may be from about 30-60 degrees, most preferably from about 40-50 degrees.

In certain example embodiments (e.g., see Figs. 1-2), the coated article including the treated DLC inclusive layer 3 (and optionally other layer(s) such as the low-E coating) on substrate 1 may be at least about 50% transparent to or transmissive of visible light rays, more preferably at least 70%, and even more preferably at least about 75%. When substrate 1 is of glass, the glass may be from about 1.5 to 5.0 mm thick. Conventional soda lime silica glass may be used as substrate 1 in certain embodiments, such glass being commercially available from Guardian Industries, Corp., Auburn Hills, Michigan. In certain other embodiments of this invention, substrate 1 may be of borosilicate glass, or of substantially transparent plastic.

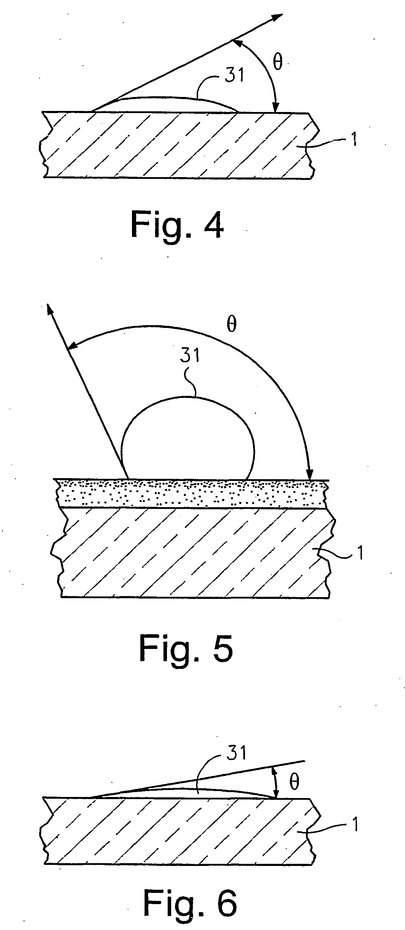

Hydrophilic performance of coating/layer 3 in any of the above embodiments is a function of contact angle θ, surface energy Υ, and/or wettability or adhesion energy W. The surface energy Υ of layer 3 may be calculated by measuring its contact angle θ. Exemplary contact angles θ are illustrated in Figs. 4-6. A hydrophilic coating or layer system 3 according to an embodiment of this invention is on the substrate of Figure 6 (i.e., low contact angle θ), while no coating of any kind is on the substrate of Figure 4 and a hydrophobic coating (high contact angle) is on the substrate of Figure 5. No coatings are illustrated in Figs. 4 and 6 for purposes of simplicity. To measure contact angle θ in an example embodiment, a sessile drop 31 of a liquid such as water is placed on the substrate (which may be coated) as shown in Figs. 4-6. A contact angle θ between the drop 31 and underlying article appears, defining an angle θ depending upon the interface tension between the three phases at the point of contact. The contact angle θ is greater in Figure 5 than in Figure 4, because the coating layer on the substrate in Figure 5 is hydrophobic (i.e., results in a higher contact angle). However, in certain embodiments of this invention, the contact angle θ in Figure 6 is low due to the barrier discharge treatment, ion beam treatment and/or hot water treatment of the DLC inclusive layer 3 that is on the substrate 1.

Generally, the surface energy Υ_{c} of a layer 3 or any other article/layer can be determined by the addition of a polar and a dispersive component, as follows: Υ_{c} = Υ_{CP} + Υ_{CD}, where Υ_{CP} is the layer's/coating's polar component and Υ_{CD} the layer's/coating's dispersive component. The polar component of the surface energy represents the interactions of the surface mainly based on dipoles, while the dispersive component represents, for example, van der Waals forces, based upon electronic interactions. Generally speaking, the higher the surface energy Υ_{c} of layer 3, the more hydrophilic the layer (and coated article) and the lower the contact angle θ. Adhesion energy (or wettability) W can be understood as an interaction between polar with polar, and dispersive with dispersive forces, between the exterior surface 9 of the coated article and a liquid thereon such as water. For a detailed explanation, see US Patent No. 6,713,179. In certain example embodiments of this invention, after barrier discharge treatment, ion beam treatment and/or hot water treatment of the DLC inclusive layer 3, the surface energy Υ_{C} of layer 3 may be at least about 20 mN/m, more preferably at least about 24 mN/m, and most preferably at least about 26 mN/m.

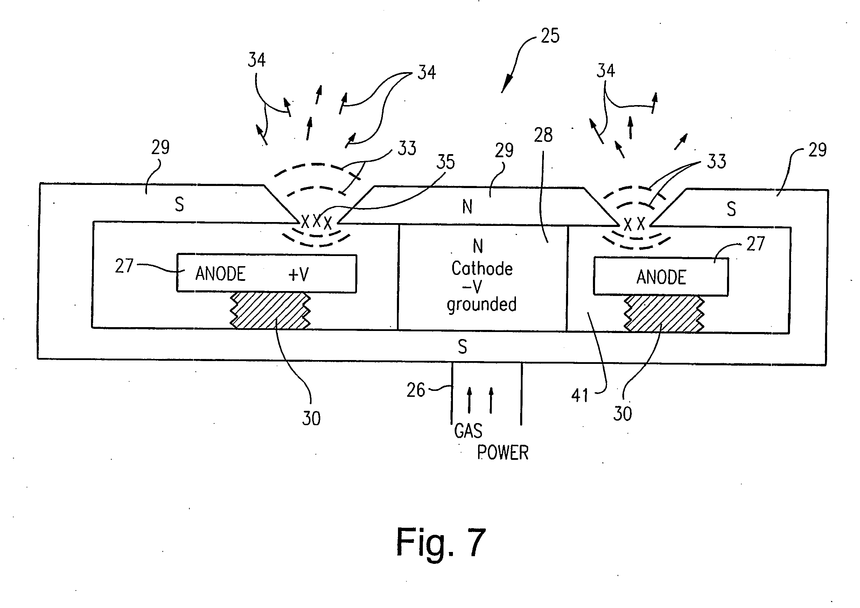

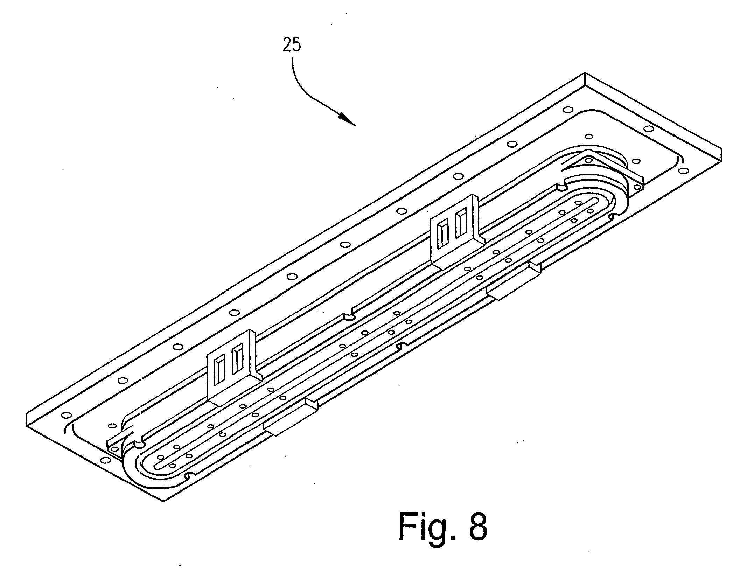

Figures 7-8 illustrate an exemplary linear or direct ion beam source 25 which may be used to deposit layer(s) 3, clean a substrate 1 before depositing layer 3, and/or ion beam treat the surface 9 of DLC inclusive layer 3 with at least oxygen ions to reduce its contact angle θ. Ion beam source (or ion source) 25 includes gas/power inlet 26, racetrack-shaped anode 27, grounded cathode magnet portion 28, magnet poles 29, and insulators 30. An electric gap is defined between the anode 27 and the cathode 29. A 3kV or any other suitable DC power supply may be used for source 25 in some embodiments. The oxygen and/or other gas(es) discussed herein for use in the ion source during the ion beam treatment, DLC deposition, or the like may be introduced into the source via gas inlet 26, or via any other suitable location. Linear source ion deposition allows for substantially uniform deposition of DLC inclusive layer 3 as to thickness and stoichiometry. Ion beam source 25 is based upon a known gridless ion source design. The linear source may include a linear shell (which is the cathode and grounded) inside of which lies a concentric anode (which is at a positive potential). This geometry of cathode-anode and magnetic field 33 may give rise to a close drift condition. Feedstock gases (e.g., oxygen inclusive gas as discussed above used in ion beam treating surface 9 to make contact angle drop, or C₂H₂ used for DLC deposition) may be fed through the cavity 41 between the anode 27 and cathode 29. The voltage used between the anode 27 and cathode 29 during ion beam treatment of surface 9 with at least oxygen ions is preferably at least 800 V, more preferably at least 1,000 V, and most preferably from about 1,000 to 2,000 V. Moreover, during such ion beam treatment, the oxygen inclusive gas in the source may be provided in terms of a gas flow of from about 100 to 200 sccm in certain example embodiments of this invention, more preferably from about 135 to 180 sccm. The electrical energy between the anode and cathode then cracks the gas to produce a plasma within the source. The ions 34 are expelled out and directed toward the substrate 1 in the form of an ion beam. The ion beam may be diffused, collimated, or focused. Example ions 34 are shown in Figure 7. A linear source as long as 0.5 to 4 meters may be made and used in certain example instances, although sources of different lengths are anticipated in different embodiments of this invention. Electron layer 35 is shown in Figure 7 and completes the circuit. Example but non-limiting ion beam sources that may be used to deposit layer 3 and/or to ion beam treat the same to cause its contact angle to drop are disclosed in U.S. Patent Nos. 6,303,226, 6,359,388, 6,037,717, and 5,656,891. For purposes of example only, DLC inclusive layer 3 may be ion beam deposited on substrate 1 using source 25 of Figs. 7-8 in a manner(s) described in any of U.S. Patent Nos. 6,303,225, 6,303,226, 6,368,664, and/or 6,359,388. A hydrocarbon feedstock gas such as C₂H₂ may be used in the source in order to ion beam deposit the DLC inclusive layer 3. When it is desired to hydrogenate layer 3, for example, a dopant gas may be produced by bubbling a carrier gas (e.g. C₂H₂) through a precursor monomer (e.g. TMS or 3MS) held at about 70 degrees C (well below the flashing point). Acetylene feedstock gas (C₂H₂) is used in certain embodiments to prevent or minimize/reduce polymerization and to obtain an appropriate energy to allow the carbon and/or hydrogen ions to penetrate the article and subimplant therein, thereby causing the layer 3 to grow. Other suitable gases, including polar inducing dopant gases, may also be used in the source to create the ions 34. After the DLC inclusive layer 3 has been deposited (via ion beam deposition or any other suitable technique), its surface is ion beam treated and/or hot water treated as discussed above in order to decrease its contact angle. It is believed that the ion beam treatment, barrier discharge treatment, and/or hot water treatment results in oxidation and causes a thin carbon-oxide layer/portion to form at the surface of the layer 3 (e.g., including C=O and/or O-C=O bonds, discussed above for example). This thin at least partially oxidized surface layer portion has a fair amount of attraction to water molecules (polar bonds), thus explaining its hydrophilicity. This thin carbon oxide inclusive layer/portion may be from about 1-30 Å thick, more likely/preferably about 5-15 Å thick. This thin carbon oxide inclusive portion is believed to seal off the remainder of the layer 3 from the ambient atmosphere, so as to prevent further oxidation (i.e., the bulk of the hard sp³ carbon-carbon bonds in the bulk of the layer 3 are thus resistant to oxidation so that the layer maintains its scratch resistance and the like). This sealing off prevents degradation of the bulk of layer 3, while at the same time providing hydrophilic properties (i.e., low contact angle) at the surface thereof.

## Claims

1. A method of making a coated article, the method comprising:
depositing a layer comprising diamond-like carbon (DLC) on a substrate;
after said depositing, subjecting the layer comprising DLC to a barrier discharge treatment in oxygen containing atmosphere in order to reduce a contact angle θ of the layer comprising DLC wherein the barrier discharge treatment comprises providing a first electrode above the substrate and a second electrode below the substrate so that the substrate is between the first and second electrodes,
wherein said electrodes are covered on their sides facing the substrate with a dielectric; and
causing a plasma to be generated between the first and second electrodes, wherein the plasma is at least partially located at a position above the layer comprising DLC.

2. The method of claim 1, further comprising, after subjecting the layer comprising DLC to the barrier discharge treatment, treating the layer comprising DLC with a hot liquid and/or vapor at a temperature of from 50 to 200 degrees C.

3. The method of claim 1, further comprising, prior to the barrier discharge treatment, ion beam treating the layer comprising DLC. with at least oxygen ions in order to reduce contact angle θ of the layer comprising DLC.

4. The method of claim 1, wherein the barrier discharge treatment causes the contact angle θ of the layer comprising DLC to decrease by at least 10%.

5. The method of claim 1, wherein the barrier discharge treatment causes the contact angle θ of the layer comprising DLC to decrease by at least 20%.

6. The method of claim 1. wherein the barrier discharge treatment causes the contact angle θ of the layer comprising DLC to decrease by at least 40%.

7. The method of claim 1, wherein the barrier discharge involves the generation of a plasma over at least the layer comprising DLC, and oxygen radicals from the plasma impinge upon the layer comprising DLC thereby reducing the contact angle θ of the layer comprising DLC.

8. The method of claim 1, wherein the layer comprising DLC is deposited in a vacuum atmosphere having a pressure less than atmospheric, and the barrier discharge treatment is performed at atmospheric pressure.

9. The method of claim 1, wherein the layer comprising DLC has an average hardness of at least 10 GPa.

10. The method of claim 1, wherein after said barrier discharge treatment, the layer comprising DLC has a contact angle θ of less than or equal to 30 degrees.

11. The method of claim 1, wherein after said barrier discharge treatment, the layer comprising DLC has a contact angle θ of less than or equal to 25 degrees.

12. The method of claim 1, wherein after said barrier discharge treatment, the layer comprising DLC has a contact angle θ of less than or equal to 20 degrees.

13. The method of claim 1, wherein immediately after said barrier discharge treatment, the layer comprising DLC has a contact angle θ of less than or equal to 15 degrees.

14. The method of claim 1, wherein the layer comprising DLC is amorphous.

15. The method of claim 1, wherein the layer comprising DLC is hydrogenated.

16. The method of claim 1, wherein the layer comprising DLC has more sp³ carbon-carbon bonds than sp² carbon-carbon bonds, and has an average density of at least 2.4 grams/cm².

17. The method of claim 1, further comprising ion beam treating the layer comprising DLC prior to said barrier discharge treatment, and wherein said ion beam treating comprises using at least one ion beam source that generates at least one ion beam toward a surface of the layer comprising DLC, and wherein at least oxygen gas is present in the ion beam source during the ion beam treating so that at least oxygen ions are directed toward the surface of the layer comprising DLC during said ion beam treating.

18. The method of claim 1, further comprising sputtering a coating onto the substrate before depositing the layer comprising DLC, where the coating is on either the same or opposite side of the substrate as the layer comprising DLC, and wherein the substrate is a glass substrate.

19. The method of claim 1, wherein the barrier discharge treatment causes at least an outer surface of the layer comprising DLC to oxidize.

20. The method of claim 1, wherein the layer comprising DLC is ion beam deposited on the substrate.

## Patentansprüche

1. Ein Verfahren zur Herstellung eines beschichteten Gegenstands, wobei das Verfahren aufweist:
Ablagern einer Schicht aufweisend diamantartigen Kohlenstoff (diamond-like carbon, DLC) auf ein Substrat;
nach dem Ablagern, Aussetzen der Schicht aufweisend DLC einer Barrierenentladungsbehandlung in Sauerstoff beinhaltender Atmosphäre, um einen Kontaktwinkel θ von der Schicht aufweisend DLC zu verringern, wobei die Barrierenentladungsbehandlung das Bereitstellen einer ersten Elektrode über dem Substrat und einer zweiten Elektrode unter dem Substrat, so dass das Substrat zwischen den ersten und zweiten Elektroden ist, aufweist,
wobei die Elektroden an ihren Seiten, die dem Substrat zugewandt sind, mit einem Dielektrikum bedeckt sind; und
Bewirken, dass ein Plasma zwischen den ersten und zweiten Elektroden erzeugt wird, wobei das Plasma sich zumindest teilweise bei einer Position über der Schicht aufweisend DLC befindet.

2. Das Verfahren gemäß Anspruch 1, weiter aufweisend, nach dem Aussetzen der Schicht aufweisend DLC der Barrierenentladungsbehandlung, Behandeln der Schicht aufweisend DLC mit einer heißen Flüssigkeit und/oder Dampf bei einer Temperatur von 50 bis 200 Grad C.

3. Das Verfahren gemäß Anspruch 1, weiter aufweisend, vor der Barrierenentladungsbehandlung, Ionenstrahlbehandeln der Schicht aufweisend DLC mit zumindest Sauerstoffionen um den Kontaktwinkel θ von der Schicht aufweisend DLC zu verringern.

4. Das Verfahren gemäß Anspruch 1, wobei die Barrierenentladungsbehandlung es bewirkt, dass sich der Kontaktwinkel θ von der Schicht aufweisend DLC um zumindest 10 % verringert.

5. Das Verfahren gemäß Anspruch 1, wobei die Barrierenentladungsbehandlung es bewirkt, dass sich der Kontaktwinkel θ von der Schicht aufweisend DLC um zumindest 20 % verringert.

6. Das Verfahren gemäß Anspruch 1, wobei die Barrierenentladungsbehandlung es bewirkt, dass sich der Kontaktwinkel θ von der Schicht aufweisend DLC um zumindest 40 % verringert.

7. Das Verfahren gemäß Anspruch 1, wobei die Barrierenentladung die Erzeugung von einem Plasma über zumindest der Schicht aufweisend DLC umfasst, und wobei Sauerstoffradikale von dem Plasma in die Schicht aufweisend DLC eindringen, dabei den Kontaktwinkel θ von der Schicht aufweisend DLC verringernd.

8. Das Verfahren gemäß Anspruch 1, wobei die Schicht aufweisend DLC in einer Vakuumatmosphäre abgelagert wird, die einen Druck kleiner als atmosphärisch hat, und wobei die Barrierenentladungsbehandlung bei atmosphärischem Druck durchgeführt wird.

9. Das Verfahren gemäß Anspruch 1, wobei die Schicht aufweisend DLC eine durchschnittliche Härte von zumindest 10 GPa hat.

10. Das Verfahren gemäß Anspruch 1, wobei nach der Barrierenentladungsbehandlung die Schicht aufweisend DLC einen Kontaktwinkel θ von weniger als oder gleich 30 Grad hat.

11. Das Verfahren gemäß Anspruch 1, wobei nach der Barrierenentladungsbehandlung die Schicht aufweisend DLC einen Kontaktwinkel θ von weniger als oder gleich 25 Grad hat.

12. Das Verfahren gemäß Anspruch 1, wobei nach der Barrierenentladungsbehandlung die Schicht aufweisend DLC einen Kontaktwinkel θ von weniger als oder gleich 20 Grad hat.

13. Das Verfahren gemäß Anspruch 1, wobei unmittelbar nach der Barrierenentladungsbehandlung die Schicht aufweisend DLC einen Kontaktwinkel θ von weniger als oder gleich 15 Grad hat.

14. Das Verfahren gemäß Anspruch 1, wobei die Schicht aufweisend DLC amorph ist.

15. Das Verfahren gemäß Anspruch 1, wobei die Schicht aufweisend DLC hydriert ist.

16. Das Verfahren gemäß Anspruch 1, wobei die Schicht aufweisend DLC mehr sp³ Kohlenstoff-Kohlenstoffbindungen als sp² Kohlenstoff-Kohlenstoffbindungen, und eine durchschnittliche Dichte von zumindest 2,4 Gramm/cm² hat.

17. Das Verfahren gemäß Anspruch 1, weiter aufweisend, Ionenstrahlbehandeln der Schicht aufweisend DLC vor der Barrierenentladungsbehandlung, und wobei die Ionenstrahlbehandlung die Verwendung von zumindest einer Ionenstrahlquelle aufweist, die zumindest einen Ionenstrahl erzeugt, hin zu einer Oberfläche von der Schicht aufweisend DLC, und wobei zumindest Sauerstoffgas in der Ionenstrahlquelle während der Ionenstrahlbehandlung vorhanden ist, so dass zumindest Sauerstoffionen hin zu der Oberfläche von der Schicht aufweisend DLC während der Ionenstrahlbehandlung gerichtet werden.

18. Das Verfahren gemäß Anspruch 1, weiter aufweisend, das Sputtern einer Beschichtung auf das Substrat vor dem Ablagern der Schicht aufweisend DLC, wobei die Beschichtung entweder auf derselben oder der gegenüberliegenden Seite von dem Substrat ist wie die Schicht aufweisend DLC, und wobei das Substrat ein Glassubstrat ist.

19. Das Verfahren gemäß Anspruch 1, wobei die Barrierenentladungsbehandlung es bewirkt, dass zumindest eine äußere Oberfläche von der Schicht aufweisend DLC oxidiert.

20. Das Verfahren gemäß Anspruch 1, wobei die Schicht aufweisend DLC auf dem Substrat ionenstrahlabgelagert ist.

## Revendications

1. Un procédé de fabrication d'un article revêtu, le procédé comprenant :
le dépôt d'une couche comprenant du carbone semblable au diamant (DLC) sur un substrat ;
après ledit dépôt, la soumission de la couche comprenant du DLC à un traitement de décharge de barrière dans une atmosphère contenant de l'oxygène afin de réduire un angle de contact θ de la couche comprenant du DLC, le traitement de décharge barrière comprenant la mise en place d'une première électrode au-dessus du substrat et
d'une seconde électrode au-dessous du substrat de sorte que le substrat se trouve entre la première et la seconde électrode,
lesdites électrodes étant recouvertes d'un diélectrique sur leur face tournée vers le substrat ; et
l'obtention de la production d'un plasma entre les première et seconde électrodes,
le plasma étant au moins partiellement situé en une position au-dessus de la couche comprenant du DLC.

2. Le procédé de la revendication 1, comprenant en outre, après avoir soumis la couche comprenant du DLC au traitement de décharge barrière, le traitement de la couche comprenant du DLC par une vapeur et/ou un liquide chaud à une température comprise entre 50 et 200°C.

3. Le procédé de la revendication 1, comprenant en outre, avant le traitement de décharge barrière, un traitement par faisceaux d'ions de la couche comprenant du DLC par au moins des ions oxygène afin de réduire l'angle de contact θ de la couche comprenant du DLC.

4. Le procédé de la revendication 1, dans lequel le traitement de décharge barrière produit une diminution d'au moins 10 % de l'angle de contact θ de la couche comprenant du DLC.

5. Le procédé de la revendication 1, dans lequel le traitement de décharge barrière produit une diminution d'au moins 20 % de l'angle de contact θ de la couche comprenant du DLC.

6. Le procédé de la revendication 1, dans lequel le traitement de décharge barrière produit une diminution d'au moins 40 % de l'angle de contact θ de la couche comprenant du DLC.

7. Le procédé de la revendication 1, dans lequel la décharge barrière implique la génération d'un plasma au-dessus d'au moins la couche comprenant du DLC, avec des radicaux oxygène provenant du plasma frappant la couche comprenant du DLC afin de réduire ainsi l'angle de contact θ de la couche comprenant du DLC.

8. Le procédé de la revendication 1, dans lequel la couche comprenant du DLC est déposée dans une atmosphère sous vide présentant une pression inférieure à la pression atmosphérique, et le traitement de décharge barrière est exécuté à pression atmosphérique.

9. Le procédé de la revendication 1, dans lequel la couche comprenant du DLC présente une dureté moyenne d'au moins 10 GPa.

10. Le procédé de la revendication 1, dans lequel après ledit traitement de décharge barrière, la couche comprenant du DLC présente un angle de contact θ inférieur ou égal à 30 degrés.

11. Le procédé de la revendication 1, dans lequel après ledit traitement de décharge barrière, la couche comprenant du DLC présente un angle de contact θ inférieur ou égal à 25 degrés.

12. Le procédé de la revendication 1, dans lequel après ledit traitement de décharge barrière, la couche comprenant du DLC présente un angle de contact θ inférieur ou égal à 20 degrés.

13. Le procédé de la revendication 1, dans lequel après ledit traitement de décharge barrière, la couche comprenant du DLC présente un angle de contact θ inférieur-ou -égal à 15 degrés.

14. Le procédé de la revendication 1, dans lequel la couche comprenant du DLC est amorphe.

15. Le procédé de la revendication 1, dans lequel la couche comprenant du DLC est hydrogénée.

16. Le procédé de la revendication 1, dans lequel la couche comprenant du DLC présente plus de liaisons carbone-carbone sp³ que de liaisons carbone-carbone sp², et présente une densité moyenne d'au moins 2,4 g/cm².

17. Le procédé de la revendication 1, comprenant en outre le traitement par faisceaux d'ions de la couche comprenant du DLC avant le traitement de décharge barrière, et dans lequel ledit traitement par faisceaux d'ions comprend l'utilisation d'au moins une source de faisceaux d'ions qui génère au moins un faisceau d'ions en direction d'une surface de la couche comprenant du DLC, et dans lequel au moins de l'oxygène gazeux est présent dans la source de faisceaux d'ions durant le traitement par faisceaux d'ions de sorte qu'au moins des ions oxygène soient dirigés vers la surface de la couche comprenant du DLC pendant ledit traitement par faisceaux d'ions.

18. Le procédé de la revendication 1, comprenant en outre la pulvérisation cathodique d'un revêtement sur le substrat avant dépôt de la couche comprenant du DLC, le revêtement étant soit du même côté soit du côté opposé du substrat que la couche comprenant du DLC, et dans lequel le substrat est un substrat de verre.

19. Le procédé de la revendication 1, dans lequel le traitement par décharge barrière provoque l'oxydation d'au moins une surface extérieure de la couche comprenant du DLC.

20. Le procédé de la revendication 1, dans lequel la couche comprenant du DLC est déposée par faisceau ionique sur le substrat.
